# EUROPEAN PATENT APPLICATION

(11) **EP 4 379 826 A1**
(43) Date of publication of application: **05.06.2024**
(21) Application number: 22849840.8
(22) Date of filing: 25.07.2022
(51) Int. Cl.: H01L 33/50, F21S 41/141, H01L 33/48

(54) **LIGHT-EMITTING MODULE AND HEAD LAMP HAVING SAME**

(30) Priority: 30.07.2021 US 202163227541 P
(71) Applicant: Seoul Semiconductor Co., Ltd., Gyeonggi-do 15429 (KR)
(72) Inventor: KIM, Hye In, Ansan-Si Gyeonggi-do 15429 (KR); SON, Jung Hun, Ansan-Si Gyeonggi-do 15429 (KR)
(74) Representative: Isarpatent
(86) International application number: PCT/KR2022/010910
(87) International publication number: WO 2023/008864

(57) **Abstract**

A light-emitting module according to an embodiment comprises: a substrate; a plurality of light-emitting diode chips which are disposed on the substrate; a plurality of wavelength converters which are disposed on the plurality of light-emitting diode chips respectively; and a white wall which surrounds the plurality of light-emitting diode chips and the plurality of wavelength converters, wherein each of the plurality of wavelength converters includes a side surface which is inclined at an inclination angle of 80 degrees or less to the upper surface of the wavelength converter.

## Description

### [Technical Field]

The present disclosure relates to a light emitting module and a headlamp having the same.

### [Background Art]

A light emitting diode chip is a semiconductor device that emits light generated by the recombination of electrons and holes, and has recently been used in various technical fields such as displays, automobile lamps, and general lighting. The light emitting diode chip has a long lifespan, a low power consumption, and a high response speed, thereby being used in various technical fields such as automobile lamps and display devices.

Automobile headlamps irradiate a front side of a vehicle in a direction in which it travels, helping the driver to recognize the front side. In addition, the beam irradiated from the headlamp shall not cause a dazzle to a driver driving in the opposite direction. To meet these requirements, adaptive driving beam (ADB) system was introduced.

An ADB head lamp typically includes an optical device that can remove light irradiated to a selected local region. Generally, a plurality of light emitting diodes is arranged to emit light in a desired direction, and each of the light emitting diodes is independently driven by a CAN signal to block light in a selected region. By using an ADB system, high beams may be used without causing dazzle to drivers of vehicles in the opposite direction or drivers of vehicles ahead, thereby ensuring sufficient night vision for the drivers.

The ADB system uses a camera sensor to check the locations of vehicles in the opposite direction or vehicles ahead. However, as the reliability of a current camera sensor is not high, light irradiated to a relatively larger region than a region corresponding to a vehicle's position is removed. That is, there is a problem that a dark zone from which light is removed is unnecessarily large. However, the reliability of the camera sensor continues to increase, and accordingly, the ADB system is expected to require more precise control. Accordingly, a head lamp with dozens of light emitting diodes arranged is currently used, but it is expected that a pixel light source with thousands or tens of thousands of light emitting diodes arranged will be used in the future.

Meanwhile, when light emitting diode chips are densely arranged, a glare of light emitted from the light emitting diode chips emerges as an important problem. When a glare phenomenon occurs on a side surface of an individual light emitting diode applied to an automobile lamp, a cutoff line, which is a boundary line between a bright zone where light emitted from the automobile lamp is irradiated in front and a dark zone from which light has been removed, becomes unclear. Due to this, it is difficult to precisely control the dark zone, and the driver radiates light to unnecessary regions, which may interfere with the vision of other drivers.

### [Disclosure]

### [Technical Problem]

Exemplary embodiments of the present disclosure provide a light emitting module including at least two light emitting diode chips, which may prevent a glare of the light emitting diode chips.

Exemplary embodiments of the present disclosure provide a light emitting module suitable for an ADB system for precisely controlling dark zones and a headlamp including the same.

### [Technical Solution]

A light emitting module according to an embodiment includes: a substrate; a plurality of light emitting diode chips disposed on the substrate; a plurality of wavelength converters respectively disposed on the plurality of light emitting diode chips; and a white wall surrounding the plurality of light emitting diode chips and the plurality of wavelength converters, in which each of the plurality of wavelength converters includes a side surface inclined at an inclination angle of 80 degrees or less with respect to an upper surface of the wavelength converter.

A light emitting module according to an embodiment includes: a substrate; a plurality of light emitting diode chips disposed on the substrate; a plurality of wavelength converters respectively disposed on the plurality of light emitting diode chips; and a white wall surrounding the plurality of light emitting diode chips and the plurality of wavelength converters, in which intervals between the wavelength converters are 100 um or less, and in a luminance graph obtained by driving a single light emitting diode chip, a luminance at a position where it is 250 µm away from an edge of the wavelength converter corresponding to the single light emitting diode chip is less than 1/250 of a maximum luminance.

A headlamp according to an embodiment includes a light emitting module, in which the light emitting module includes: a substrate; a plurality of light emitting diode chips disposed on the substrate; a plurality of wavelength converters respectively disposed on the plurality of light emitting diode chips; and a white wall surrounding the plurality of light emitting diode chips and the plurality of wavelength converters, in which each of the plurality of wavelength converters includes a side surface inclined at an inclination angle of 80 degrees or less with respect to an upper surface of the wavelength converter.

A light emitting module according to another embodiment includes a substrate, a single light emitting diode chip disposed on the substrate, a single wavelength converter disposed on the light emitting diode chip, and a white wall surrounding the light emitting diode chip and the wavelength converter, in which a width of an upper surface of the wavelength converter is greater than a width of an upper surface of the light emitting diode chip.

### [Description of Drawings]

FIG. 1A is a schematic plan view illustrating a light emitting module according to an embodiment of the present disclosure.
FIG. 1B is an enlarged plan view of a portion of FIG. 1A.
FIG. 1C is a plan view illustrating an electrode structure of a light emitting module according to an embodiment of the present disclosure.
FIG. 1D is a rear view illustrating a light emitting module according to an embodiment of the present disclosure.
FIG. 2 is a schematic cross-sectional view taken along line A-A' in FIG. 1B.
FIG. 3 is a schematic cross-sectional view illustrating a light emitting module according to another embodiment of the present disclosure.
FIG. 4 is a schematic cross-sectional view illustrating a light emitting module according to another embodiment of the present disclosure.
FIG. 5A is a graph illustrating a method of evaluating a glare of a light emitting module.
FIG. 5B is a graph illustrating another method of evaluating a glare of a light emitting module.
FIG. 6A is a graph showing glare characteristics of a light emitting module according to an embodiment of the present disclosure according to the evaluation method of FIG. 5A.
FIG. 6B is a graph showing glare characteristics of a light emitting module according to an embodiment of the present disclosure according to the evaluation method of FIG. 5B.
FIG. 7 is a schematic plan view illustrating a light emitting module according to another embodiment of the present disclosure.
FIG. 8 is a schematic cross-sectional view taken along line B-B' in FIG. 7.

### [Best Mode]

Hereinafter, embodiments of the present disclosure will be described in detail with reference to the accompanying drawings. The following embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of devices can be exaggerated for clarity and descriptive purposes. When an element or layer is referred to as being "disposed above" or "disposed on" another element or layer, it can be directly "disposed above" or "disposed on" the other element or layer or intervening devices or layers can be present. Throughout the specification, like reference numerals denote like devices having the same or similar functions.

A light emitting module according to an embodiment includes: a substrate; a plurality of light emitting diode chips disposed on the substrate; a plurality of wavelength converters respectively disposed on the plurality of light emitting diode chips; and a white wall surrounding the plurality of light emitting diode chips and the plurality of wavelength converters, in which each of the plurality of wavelength converters includes a side surface inclined at an inclination angle of 80 degrees or less with respect to an upper surface of the wavelength converter.

The substrate may include an upper surface circuit pattern, a lower surface circuit pattern, and a via connecting the upper surface circuit pattern and the lower surface circuit pattern.

An upper surface area of each of the wavelength converters may be larger than a lower surface area thereof.

The lower surface area of the wavelength converters may be in a range of 95% to 105% of an upper surface area of the light emitting diode chip.

The lower surface area of the wavelength converters may be smaller than the upper surface area of the light emitting diode chip.

Meanwhile, the intervals between the wavelength converters may be 100 um or less. Furthermore, the intervals between the wavelength converters may be 70 um or less. Moreover, the intervals between the wavelength converters may be 50 um or less.

The inclination angle may be 80 degrees or less, and further, 70 degrees or less.

Thicknesses of the wavelength converters may be smaller than those of the light emitting diode chips. The thicknesses of the wavelength converters may be about 120 um or less, and further, about 100 um or less.

An interval between lower surfaces of the wavelength converters may be greater than an interval between the upper surfaces of the wavelength converters by more than 1/2 time of the thickness of the wavelength converter.

In an embodiment, the intervals between the wavelength converters may be 100 um or less, and in a luminance graph obtained by driving a single light emitting diode chip, a luminance at a position where it is 250 µm away from an edge of the wavelength converter corresponding to the single light emitting diode chip may be less than 1/250 of a maximum luminance. Moreover, the intervals between the wavelength converters may be 50 um or less.

In an embodiment, the intervals between the wavelength converters may be 100 um or less, and in the luminance graph obtained by driving the single light emitting diode chip, a luminance at a position where it is 250 um away from a point showing 10% luminance of the maximum luminance thereof may be less than 1/200 of the maximum luminance. Moreover, the intervals between the wavelength converters may be 50 um or less.

A light emitting module according to an embodiment includes: a substrate; a plurality of light emitting diode chips disposed on the substrate; a plurality of wavelength converters respectively disposed on the plurality of light emitting diode chips; and a white wall surrounding the plurality of light emitting diode chips and the plurality of wavelength converters, in which intervals between the wavelength converters are 100 um or less, and in a luminance graph obtained by driving a single light emitting diode chip, a luminance at a position where it is 250 µm away from an edge of the wavelength converter corresponding to the single light emitting diode chip is less than 1/250 of a maximum luminance.

The intervals between the wavelength converters may be 70 um or less, and further, 50 um or less.

Thicknesses of the wavelength converters may be smaller than those of the light emitting diode chips. As an example, the thicknesses of the wavelength converters may be about 120 um or less, and further, 100 um or less.

A headlamp according to an embodiment includes a light emitting module, in which the light emitting module includes: a substrate; a plurality of light emitting diode chips disposed on the substrate; a plurality of wavelength converters respectively disposed on the plurality of light emitting diode chips; and a white wall surrounding the plurality of light emitting diode chips and the plurality of wavelength converters, in which each of the plurality of wavelength converters includes a side surface inclined at an inclination angle of 80 degrees or less with respect to an upper surface of the wavelength converter.

Intervals between the wavelength converters may be 100 um or less, and in a luminance graph obtained by driving a single light emitting diode chip, a luminance at a position where it is 250 µm away from an edge of the wavelength converter corresponding to the single light emitting diode chip may be less than 1/250 of a maximum luminance. Moreover, the intervals between the wavelength converters may be 50 um or less.

In an embodiment, the intervals between the wavelength converters may be 100 um or less, and in the luminance graph obtained by driving the single light emitting diode chip, a luminance at a position where it is 250 um away from a point showing 10% luminance of the maximum luminance thereof may be less than 1/200 of the maximum luminance. Moreover, the intervals between the wavelength converters may be 50 um or less.

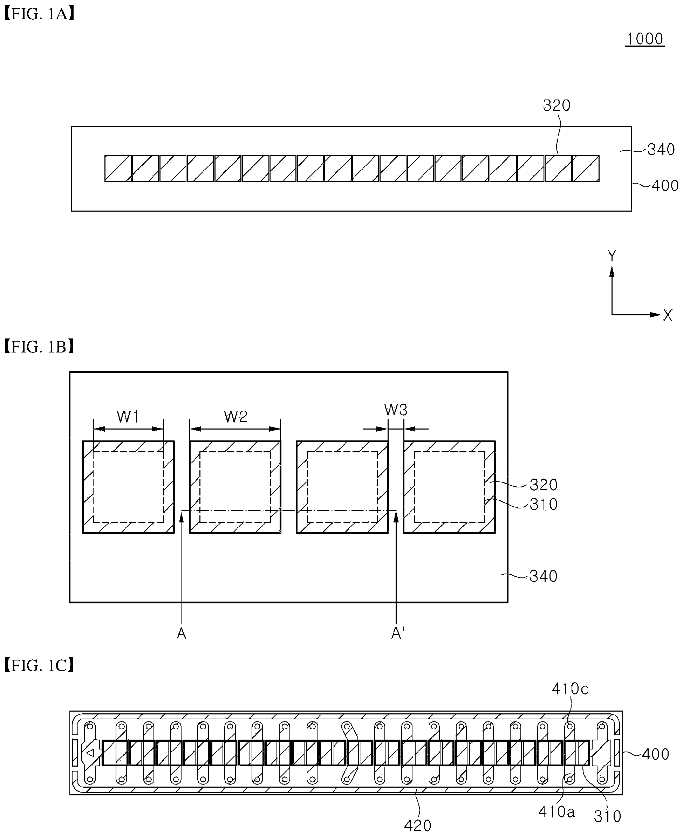

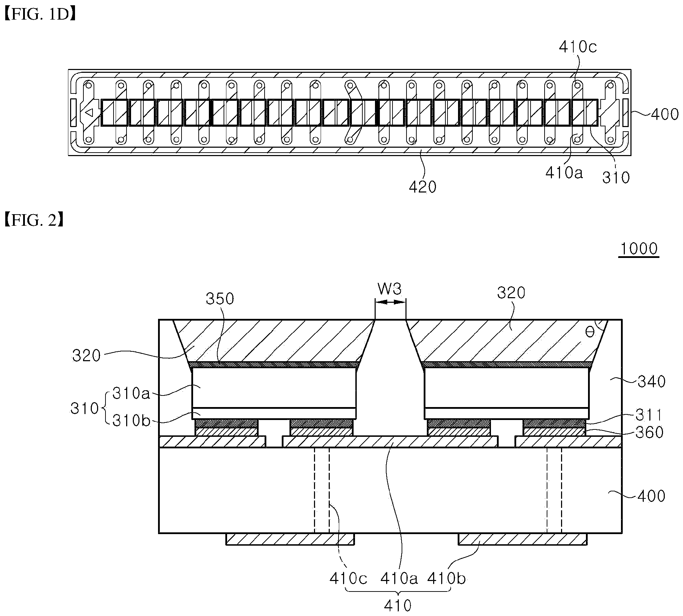

FIG. 1A is a schematic plan view illustrating a light emitting module according to an embodiment of the present disclosure, FIG. 1B is an enlarged plan view of a portion of FIG. 1A (region indicated by a dotted line), FIG. 1C is a plan view illustrating an electrode structure of a light emitting module according to an embodiment of the present disclosure, and FIG. 1D is a rear view illustrating a light emitting module according to an embodiment of the present disclosure. Meanwhile, FIG. 2 is a schematic cross-sectional view taken along line A-A' of FIG. 1B.

Referring to FIGs. 1A through 1D, and FIG. 2, a light emitting module 1000 may include a substrate 400, a plurality of light emitting diode chips 310, wavelength converters 320, and a white wall 340. The light emitting module 1000 may further include a circuit pattern 410 (410a, 410b, 410c), a warpage prevention pattern 420, a light-transmitting adhesive layer 350, and a bonding material 360.

The substrate 400 may be an insulating or conductive substrate. The substrate 400 may include a ceramic material with favorable thermal conductivity, such as AlN.

In addition, the substrate 400 may include the circuit pattern 410 on an upper and/or lower surface. As an example, the substrate 400 may include an upper surface circuit pattern 410a, a lower surface circuit pattern 410b, and a via 410c.

The upper surface circuit pattern 410a has a structure on which electrodes 311 of the light emitting diode chips can be mounted. The upper surface circuit pattern 410a is formed to prevent an n electrode and a p electrode of the light emitting diode chip from short-circuiting each other, and each of the light emitting diode chips 310 is mounted on pads spaced apart from one another of the upper surface circuit pattern 410a.

A plurality of lower surface circuit patterns 410b is provided to supply power to each of the light emitting diode chips 310. Although FIG. 1D shows the pads being divided into upper and lower parts, upper and lower pads may be connected to one another. However, by separating the upper and lower pads from one another, when the light emitting module 1000 is mounted on a headlamp, an adhesion may be enhanced.

Meanwhile, the via 410c may be formed by forming a through hole passing through the substrate 400, and then filling it with a conductive material. The vias 410c electrically connect the upper surface circuit pattern 410a and the lower surface circuit pattern 410b. The via 410c may have a structure with a constant width from an upper surface to a lower surface of the substrate 400, but the inventive concepts are not limited thereto. For example, the via 410c may have a structure where the width thereof narrows toward the inside from the upper surface and the lower surface of the substrate 400.

The circuit patterns 410 may be electrically connected to the plurality of light emitting diode chips 310 disposed on the substrate 400, and may be electrically connected to an external power source through a portion exposed at a lower portion of the substrate 400 to supply power to the plurality of light emitting diode chips 310.

Each of the plurality of light emitting diode chips 310 may be electrically connected to separate electrodes by the circuit pattern 410. By separately connecting the power supplied to the electrodes, the plurality of light emitting diode chips 310 may be individually driven. However, the inventive concepts are not limited thereto, and the electrodes may be electrically connected to one another. In addition, the light emitting module 1000 may further include an additional control portion, and the driving of the plurality of light emitting diode chips 310 may be controlled by the control portion.

The warpage prevention pattern 420 may be disposed around the upper surface circuit pattern 410a. The warpage prevention pattern 420 may be formed in addition to the upper surface circuit pattern 410a to prevent the substrate 400 from being warped. When a total area of the lower surface circuit pattern 410b is larger than a total area of the upper circuit pattern 410b, the substrate 400 is likely to be warped. By forming the warpage prevention pattern 420 on the upper surface of the substrate 400 in addition to the upper surface circuit pattern 410a, the warpage of the substrate 400 may be prevented. The warpage prevention pattern 420 may be formed to surround the upper surface circuit pattern 410a. The warpage prevention pattern 420 may be formed in a shape of a line shape forming a closed loop, but may also be formed as a discontinuous line with a portion thereof removed, as shown in FIG. 1C.

Meanwhile, in this embodiment, the via 410c is shown and described as connecting the upper surface circuit pattern 410a and the lower surface circuit pattern 410b, but the inventive concepts are not limited thereto. For example, in another embodiment of the present disclosure, the upper and lower surface circuit patterns 410a and 410b may be connected through a connection pattern (not shown in the drawings) formed along a side surface of the substrate 400 instead of the via 410c.

The plurality of light emitting diode chips 310 is mounted on the substrate 400, and the wavelength converter 320 is disposed on each of the light emitting diode chips 310. The plurality of light emitting diode chips 310 may have peak wavelengths in a same color range. In addition, the plurality of light emitting diode chips 310 may have different peak wavelengths from one another. In this embodiment, 18 light emitting diode chips 310 and wavelength converters 320 are shown as being arranged in an x-direction, but the present disclosure is not limited to a specific number, and any number of two or more light emitting diode chips 310 may be arranged on the substrate 400. In addition, in this embodiment, the light emitting diode chips 310 are shown as being arranged in a row, but the inventive concepts are not limited thereto. That is, the plurality of light emitting diode chips 310 may be arranged in x and y directions, respectively, and thus, the light emitting diode chips 310 may be arranged in a matrix having a plurality of rows and a plurality of columns.

The light emitting diode chip 310 may include a growth substrate 310a and a semiconductor stack 310b including an n-type semiconductor layer, a p-type semiconductor layer, and an active layer interposed between the n-type semiconductor layer and the p-type semiconductor layer. In addition, the light emitting diode chip 310 may include the electrodes 311 on a lower surface of the semiconductor stack 310b. The electrodes 311 may be electrically connected to the n-type semiconductor layer and the p-type semiconductor layer, respectively. Accordingly, power may be supplied to the light emitting diode chip 310 through the electrodes 311, and light may be emitted.

As in the embodiment of the present disclosure, the plurality of light emitting diode chips 310 may be bonded on the substrate 400. The electrodes 311 of the plurality of light emitting diode chips 310 may be connected to the circuit pattern 410 formed on the substrate 400, respectively. The electrodes 311 may be bonded to the circuit pattern 410 by eutectic bonding, without being limited thereto, and they may be connected by solder bonding, epoxy bonding, and the like. A conductive bonding material 360 for mechanically and electrically bonding the light emitting diode chips 310 may be disposed on the upper surface circuit pattern 410a of the substrate 400 to bond the plurality of light emitting diode chips 310 to the substrate 400.

The wavelength converter 320 may transmit light emitted from the light emitting diode chip 310, and may convert a wavelength of light emitted from the light emitting diode chip 310 to emit light of a specific color. In addition, the wavelength converter 320 may allow light of different colors to be emitted. As an example, the wavelength converter 320 may convert blue light emitted from the light emitting diode chip 310 into yellow light, or green light and red light such that white light is emitted from the light emitting module 1000.

The wavelength converter 320 may be a mixture of materials such as transparent resin such as silicone or epoxy, glass, ceramic, and the like, and a wavelength conversion material that converts the wavelength of light. For example, the transparent resin may be transparent silicone. The wavelength conversion material may be a phosphor, a yellow phosphor, a red phosphor, a green phosphor, and the like may be used, and further, a blue phosphor may also be used.

Examples of the yellow phosphor may be a YAG:Ce(T₃Al₃O₁₂:Ce)-based phosphor, which is a cerium (Ce)-doped yttrium (Y) aluminum (Al) garnet with a main wavelength of 530 nm to 570 nm, or a silicate-based phosphor.

Examples of the red phosphor may be a UOX(Y₂O₃:EU)-based phosphor, which consists of a compound of yttrium oxide (Y₂O₃) and europium (EU) with a main wavelength of 600 nm to 700 nm, a nitride phosphor or a fluoride phosphor. Specifically, examples of the red phosphor may be a nitrogen-containing calcium aluminosilicon (CASN or SCASN)-based phosphor (e.g., (Sr, Ca)AlSiN₃:Eu)) and a manganese-active fluoride-based phosphor (a phosphor represented by a general formula (I) A₂[M₁₋ₐMnₐF₆], (wherein in the general formula (I), A is at least one selected from a group consisting of K, Li, Na, Rb, Cs, and NH₄, M is at least one element selected from a group consisting of group 4 elements and group 14 elements, and a satisfies 0<a<0.2). A representative example of the manganese-active fluoride-based phosphor is a phosphor of manganese-active potassium fluoride silicon(e.g., K₂SiF₆:Mn). In addition, there is a manganese-active phosphor based on an oxiodohalide host lattice (phosphor represented by a general formula (II) (A₄₋ₐBₐ)_{m/2+n/2}X₂ₘ[MX₄O₂]ₙ). Wherein in the general formula (II), A is hydrogen (H) and/or deuterium (D), and B is Li, Na, K, Rb, Cs, NH₄, ND₄, and/or NR₄, herein, R is an alkyl or aryl radical, X is F and/or Cl, M is Cr, Mo, W and/or Re, 0 ≤ a ≤ 4, 0≤ m ≤ 10, and 1 ≤ n ≤ 10.

Examples of the green phosphor may be a LAP (LaPO₄:Ce, Tb)-based phosphor, a compound of phosphoric acid (PO₄), lanthanum (La), and terbium (Tb), with a main wavelength of 500 nm to 590 nm or a SiAlON-based phosphor. In addition, there may be a yttrium·aluminum· garnet-based phosphor (e.g., Y₃(Al,Ga)₅O₁₂:Ce), a lutetium·aluminum·garnet-based phosphor (e.g., Lu₃(Al, Ga)₅O₁₂:Ce), a terbium·aluminum·garnet-based phosphor (e.g., Tb₃(Al, Ga)₅O₁₂:Ce), a silicate-based phosphor (e.g., (Ba, Sr)₂SiO₄:Eu), a chlorosilicate-based phosphor (e.g., Ca₈Mg(SiO₄)₄Cl₂:Eu), a β-sialon-based phosphor (e.g., Si₆-_{z}Al_{z}O_{z}N_{8-z}:Eu (0 <z<4.2)), a SGS-based phosphor (e.g., SrGa₂S₄:Eu), and the like. As a phosphor of yellow light, examples may be an α-sialon-based phosphor (e.g., M_{z}(Si, Al)₁₂(O, N)₁₆ (Wherein, 0 <z≤2, and M is a lanthanide element excluding Li, Mg, Ca, Y and La and Ce) and the like.

An example of the blue phosphor may be a BAM (BaMgAl₁₀O₁₇:EU)-based phosphor, a compound of barium (Ba), magnesium (Mg), aluminum oxide-based materials, and europium with a main wavelength of 420 nm to 480 nm.

As shown in FIG. 2, a width W2 of an upper surface of the wavelength converter 320 may be larger than a width W1 of the light emitting diode chip 310. In addition, the width W2 of the upper surface of the wavelength converter 320 may be larger than a width of a lower surface thereof.

Meanwhile, the width of the lower surface of the wavelength converter 320 may be generally similar to the width W1 of the light emitting diode chip 310, without being limited thereto, and may be greater than or smaller than the width W1 of the light emitting diode chip 310. A side surface of the wavelength converter 320 is inclined to have an inclination angle θ with respect to the upper surface thereof. The inclination angle θ formed by the side surface of the wavelength converter 320 with respect to the upper surface may be 80 degrees or less. Furthermore, the inclination angle θ may be 76 degrees or less, further, 70 degrees or less, and furthermore, 68 degrees or less. A lower limit of the inclination angle θ is not particularly limited, but when the inclination angle θ is too small, a lower surface area of the wavelength converter 320 becomes excessively smaller than the light emitting diode chip 310, and thus, light emitted from the light emitting diode chip 310 is likely to be easily lost without being wavelength-converted. The lower surface area of the wavelength converter 320 may be in a range of 95% to 105% of an upper surface area of the light emitting diode chip 310. It is necessary to reduce the inclination angle θ while ensuring that the lower surface area of the wavelength converter 320 is not less than 95% of the upper surface area of the light emitting diode chip 310.

By making the side surface of the wavelength converter 320 inclined, a thickness of the white wall 340 disposed between the wavelength converters 320 may be increased. Accordingly, optical interference between adjacent wavelength converters 320 may be reduced, and thus, glare may be prevented.

When intervals W3 between the wavelength converters 320 are narrow, a width of the white wall 340 disposed between the wavelength converters 320 becomes small. As a result, light leakage occurs between adjacent wavelength converters 320 or between the light emitting diode chip 310 and the adjacent wavelength converter 320. Light leakage through the white wall 340 prevents a dark zone from being clearly displayed.

When the intervals between the wavelength converters 320 exceed 100 um, the white wall 340 may prevent light leakage. However, when the intervals between wavelength converters are reduced to 100 um or less, light leakage occurs through the white wall 340.

In the embodiments of the present disclosure, the side surfaces of the wavelength converters 320 are formed to be inclined even when the intervals between the wavelength converters 320 are as small as 100 um or less, and thus, the width of the white wall 340 portion between the wavelength converters 320 is relatively increased, thereby reducing light leakage and preventing glare. Furthermore, the intervals between the wavelength converters 320 may be 70 um or less, and further may be 50 um or less.

A thickness of the wavelength converter 320 may be formed larger than that of the light emitting diode chip 310, without being limited thereto, and may be formed smaller than that of the light emitting diode chip 310. For example, the thickness of the wavelength converter 320 may be 120 um or less, and further may be 100 um or less. The smaller the thickness of the wavelength converter 320, the smaller the inclination angle θ may become. The thickness of the wavelength converter 320 is generally larger than that of the light emitting diode chip 310, but in this embodiment, it may be smaller than that of the light emitting diode chip 310.

The wavelength converter 320 may be PIG (Phosphor in Glass) in which phosphor is mixed with glass. The PIG is efficient in preventing external materials such as moisture and dust from infiltrating into the light emitting module 1000. However, the present disclosure is not limited thereto, and the wavelength converter 320 may be formed by mixing a phosphor with a ceramic such as polymer resin or glass. The wavelength converter 320 may be formed of a resin such as epoxy resin or acrylic resin, and in this case, the wavelength converter 320 may be formed by applying and curing a resin containing a phosphor on the light emitting diode chip 310.

In addition, the wavelength converter 320 may further include a diffuser. The diffuser has to have a melting point that does not melt when the wavelength conversion material is sintered, and may be, for example, SiO₂, TiO₂, Al₂O₃, and the like.

The light-transmitting adhesive layer 350 may be disposed between the wavelength converter 320 and the light emitting diode chip 310. The light-transmitting adhesive layer 350 transmits light generated by the light emitting diode chip 310, and may be formed using an organic adhesive such as silicone resin or epoxy resin, or an inorganic adhesive such as low-melting-point glass.

As shown in FIG. 2, the light-transmitting adhesive layer 350 may cover at least a portion of a side surface of the growth substrate 310a of the light emitting diode chip 310. The light-transmitting adhesive layer 350 may be formed using a bonding method such as a direct bonding method, for example, compression, sintering, hydroxyl bonding method, surface activation aggregation method, atomic diffusion bonding method, and the like.

The white wall 340 may be formed to surround the light emitting diode chip 310 and the wavelength converter 320. In addition, the white wall 340 may cover the substrate 400.

An upper surface of the white wall 340 may be flush with the upper surface of the wavelength converter 320. The upper surface of the white wall 340 may be flat, without being limited thereto, and may be concave or convex.

The width of the white wall 340 disposed between the wavelength converters 320 may become narrower as it is apart from the substrate 400. For example, a minimum width of the white wall 340 may be equal to the interval W3 between the upper surfaces of the wavelength converters 320. Meanwhile, an interval between the lower surfaces of the wavelength converters 320 is larger than the W3, and for example, may be larger than the W3 by more than 1/2 time of the thickness of the wavelength converter 320. For example, when the W3 is 50 um and the thickness of the wavelength converter 320 is 100 um, the interval between the lower surfaces of the wavelength converters 320 may be 100 um or more. Accordingly, the thickness of the white wall 340 disposed between the lower surfaces of the wavelength converters 320 may also increase to, for example, 100 um or more. By increasing the width of the white wall 340 disposed in a region between the wavelength converters 320, light leakage generated through the white wall 340 may be reduced.

The white wall 340 may be made of a material that is reflective and non-conductive, and may be made of a material with high elasticity. For example, the white wall 340 may be formed of epoxy resin, silicone resin, and acrylic resin. The white wall 340 may be formed by including one or more types of the resins and a scattering or reflective material. The scattering or reflective material may include TiO₂, SiO₂, ZrO₂, F₆K₂Ti, Al₂O₃, AlN, BN, and the like. Reflection characteristics of the white wall 340 may be adjusted depending on characteristics of the material included in the resin. Therefore, the reflection characteristics of the white wall 340 may be improved to further prevent light leakage.

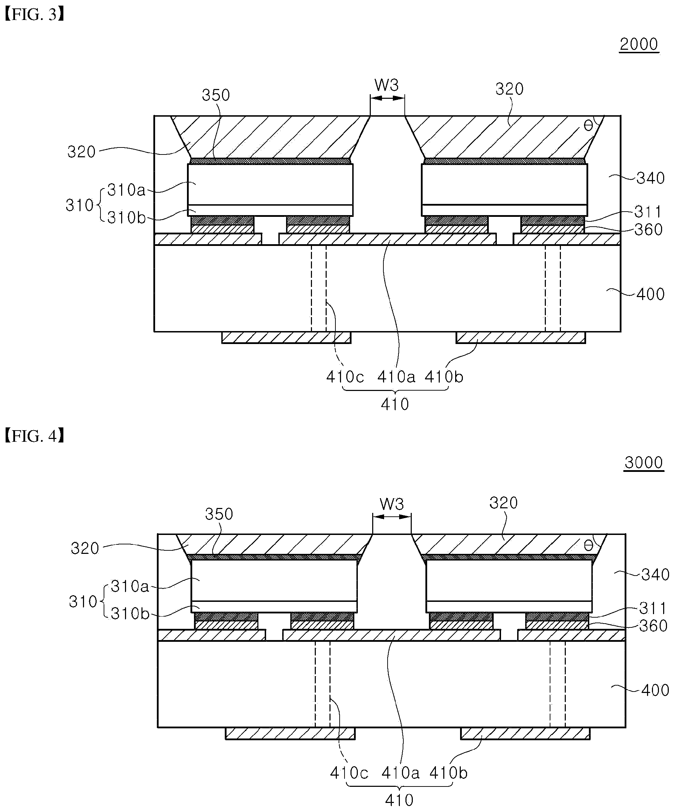

FIG. 3 is a schematic cross-sectional view illustrating a light emitting module according to another embodiment of the present disclosure.

Referring to FIG. 3, a light emitting module 2000 according to this embodiment is substantially similar to the light emitting module 1000 described with reference to FIG. 2, except that the inclination angle θ of the side surface of the wavelength converter 320 becomes relatively small, and thus, the lower surface area of the wavelength converter 320 is smaller than the upper surface area of the light emitting diode chip 310. As previously described, the lower surface area of the wavelength converter 320 may be 95% or more of the upper surface area of the light emitting diode chip 310. It is possible to preventglare by maintaining the lower surface area of the wavelength converter 320 at more than 95% of the upper surface area of the light emitting diode chip 310 and reducing the inclination angle θ under the set interval W3 between the wavelength converters 320.

FIG. 4 is a schematic cross-sectional view illustrating a light emitting module according to another embodiment of the present disclosure.

Referring to FIG. 4, a light emitting module 3000 according to this embodiment is substantially similar to the light emitting module 1000 described with reference to FIG. 2, except that the thickness of the wavelength converter 320 is relatively small. By reducing the thickness of the wavelength converter 320, the inclination angle θ may be reduced without changing the upper surface area and the lower surface area of the wavelength converter 320, thereby preventing glare.

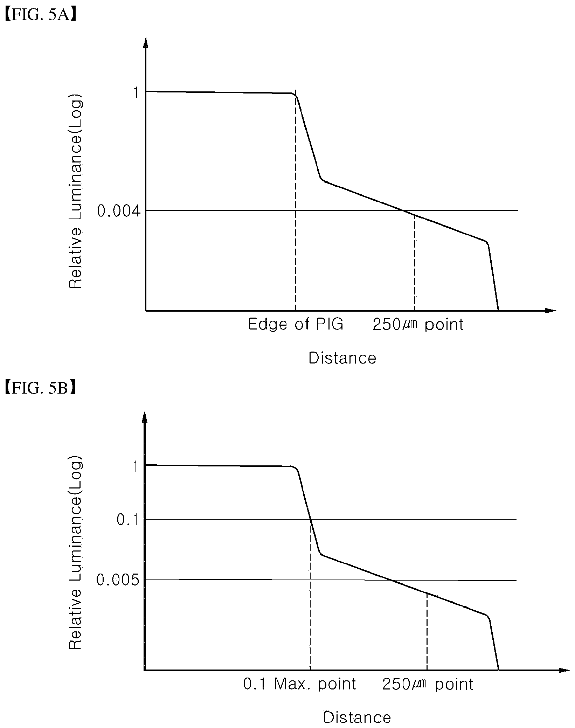

FIG. 5A is a graph illustrating a method of evaluating a glare of a light emitting module, and FIG. 5B is a graph illustrating another method of evaluating a glare of a light emitting module.

First, referring to FIG. 5A, a single light emitting diode chip 310 is driven to measure luminance to obtain a luminance value according to distance. FIG. 5A shows a typical luminance graph in log scale. A maximum luminance is normalized to 1, and each luminance is expressed as a relative value.

The light emitting module shows a high luminance at a position where a wavelength converter (e.g., PIG) is disposed, and the luminance decreases as it is apart from an edge of the PIG. The edge of the PIG may be set to a position in the graph where the luminance decreases sharply.

When there is less glare, the luminance will decrease sharply as it is apart from the edge of the PIG. To evaluate glare, the luminance at a position 250 um away from the edge of the PIG is obtained, and this luminance is compared to 1/250 of the maximum luminance. When the luminance at the position 250 um away from the edge of the PIG is less than 1/250 of the maximum luminance, the light emitting module may be evaluated as good due to less glare.

In a case of FIG. 5A, the luminance at the position 250 um away from the edge of the PIG is compared to 1/250 of the maximum luminance, but there is a disadvantage that it is difficult to accurately locate the PIG. In a case of FIG. 5B, a luminance equal to 10% of the maximum luminance, that is, using a position representing a luminance of 0.1 as a reference point, a luminance at a position 250um away from this position, is compared with 1/200 of the maximum luminance. When the luminance at the position 250 um away from the position of 10% of the maximum luminance, that is, a 0.1 Max point, is less than 1/200 of the maximum luminance, the light emitting module may be evaluated as good due to less glare.

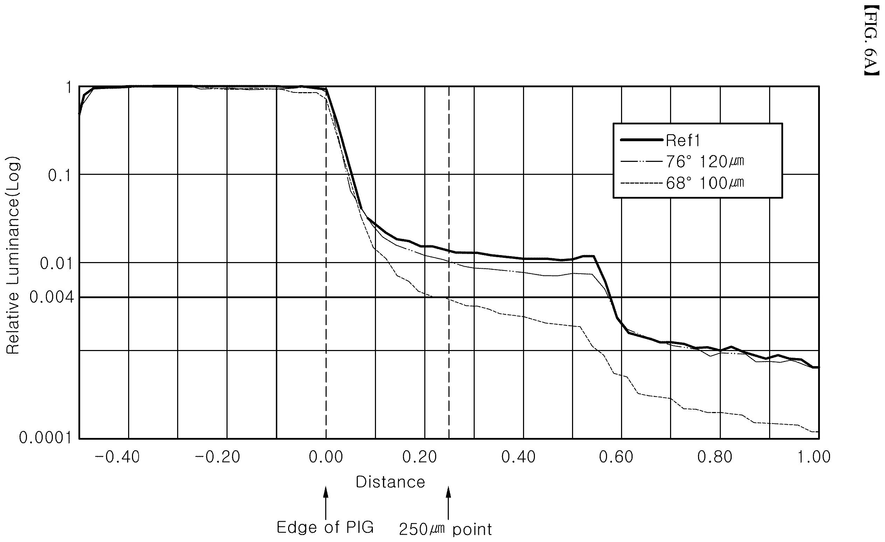

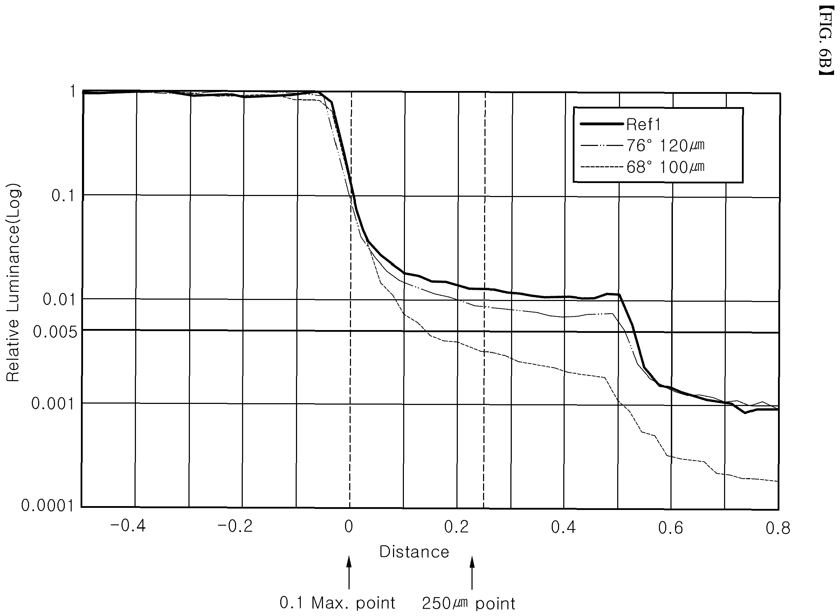

FIG. 6A is a graph showing glare characteristics of the light emitting module according to an embodiment of the present disclosure according to the evaluation method of FIG. 5A, and FIG. 6B is a graph showing glare characteristics of the light emitting module according to an embodiment of the present disclosure according to the evaluation method of FIG. 5B.

Comparative Example 1 (Ref1) has a side inclination angle θ of 90 degrees and a thickness of 120 um of a wavelength converter, Inventive Example 1 has a side inclination angle θ of 76 degrees and a thickness of 120 um of a wavelength converter, and Inventive Example 2 has a side inclination angle θ of 68 degrees and a thickness of 100 um of a wavelength converter. Herein, intervals between wavelength converters 320 were about 50 um.

Referring to FIGs. 6A and 6B, comparing the Comparative Example 1 and the Inventive Example 1, it can be seen that glare decreases as the inclination angle θ decreases. In addition, when comparing the Inventive Example 1 and the Inventive Example 2, it can be seen that glare further decreases as the thickness decreases along with the inclination angle θ.

Furthermore, in the Inventive Example 2, a luminance at a position 250 um away from an edge of the wavelength converter 320 was less than 1/250 of a maximum luminance, and using a position representing a luminance of 10% of the maximum luminance (0.1Max point) as a reference point, a luminance at a position 250 um away from this position was less than 1/200 of the maximum luminance.

According to the present disclosure, by arranging the wavelength converters 320 at intervals of 100 um or less, especially about 50 um, and maintaining the luminance at 300 lm or more using a white wall 340, glare may be prevented.

According to the embodiments of the present disclosure, it is possible to prevent glare while arranging the intervals between the wavelength converters 320 as narrow as 100 um or less. Accordingly, by densely arranging the wavelength converters 320, a light emitting module suitable for a pixel light source may be provided, and an ADB system using this may provide a more precise beam pattern to a driver. Furthermore, by using the pixel light source, it is possible to provide a headlamp or vehicle lamp that may perform more functions, such as displaying letters or pictures on the road.

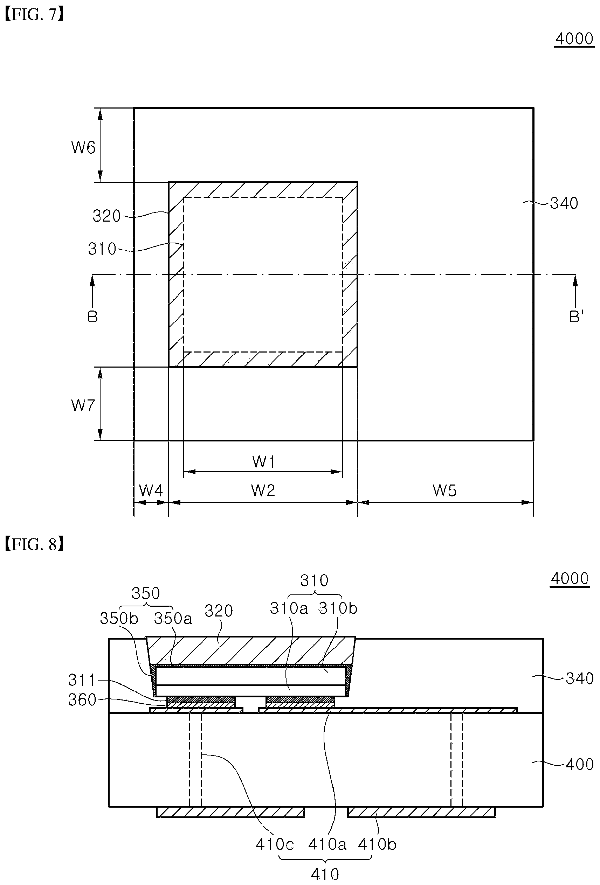

In the previous embodiments, it has been described that the light emitting module includes the plurality of light emitting diode chips and the plurality of wavelength converters, but the light emitting module may include a single light emitting diode chip and a single wavelength converter, and a plurality of such light emitting modules may be arranged and used as a light source for an ADB system. Hereinafter, a light emitting module 4000 including a single light emitting diode chip and a single wavelength converter will be described with reference to FIGs. 7 and 8.

FIG. 7 is a schematic plan view illustrating the light emitting module 4000 according to another embodiment of the present disclosure, and FIG. 8 is a schematic cross-sectional view taken along line B-B' of FIG. 7.

Referring to FIGs. 7 and 8, the light emitting module 4000 may include a substrate 400, a light emitting diode chip 310, a single wavelength converter 320, and a white wall 340. The light emitting module 4000 may further include a circuit pattern 410 (410a, 410b, 410c), a light-transmissive adhesive layer 350, and a bonding material 360.

The substrate 400, the circuit pattern 410, the bonding material 360, and the light emitting diode chip 310 are same as those of the embodiment described with reference to FIGs. 2 through 4, so detailed descriptions thereof are omitted. However, in this embodiment, a single light emitting diode chip 310 is mounted on the substrate 400, and the circuit pattern 410 is electrically connected to pads 311 of the light emitting diode chip 310 to supply power to the light emitting diode chip 310.

The light emitting diode chip 310 may include a growth substrate 310a and a semiconductor stack 310b including an n-type semiconductor layer, a p-type semiconductor layer, and an active layer interposed between the n-type semiconductor layer and the p-type semiconductor layer. In addition, the light emitting diode chip 310 may include electrodes 311 on a lower surface of the semiconductor stack 310b. The electrodes 311 may be electrically connected to the n-type semiconductor layer and the p-type semiconductor layer, respectively. The electrodes 311 may be bonded to the circuit pattern 410 by eutectic bonding, but the inventive concepts are not limited thereto, and may be connected by solder bonding, epoxy bonding, and the like. In an embodiment, to bond the plurality of light emitting diode chips 310 to the circuit board 400, a conductive bonding material 360 for mechanically and electrically bonding the light emitting diode chips 310 may be disposed on an upper surface circuit pattern 410a of the substrate 400. In another embodiment, the electrodes 311 may be directly eutectic bonded to the upper surface circuit pattern 410a.

The wavelength converter 320 is similar to that described in the previous embodiments, so redundant descriptions are omitted. In particular, a material, a type of phosphor, and a wavelength conversion function of the wavelength converter 320 are same as those described in the previous embodiment. In addition, a width W2 of an upper surface of the wavelength converter 320 may be larger than a width W1 of the light emitting diode chip 310. As shown in FIG. 7, an upper surface area of the wavelength converter 320 is larger than that of the light emitting diode chip 310, and an entire upper surface of the light emitting diode chip 310 is covered by the wavelength converter 320.

Meanwhile, in this embodiment, a width of a lower surface of the wavelength converter 320 may be smaller than or equal to the width W2 of the upper surface. The width of the lower surface of the wavelength converter 320 may be larger than the width W1 of the light emitting diode chip 310. A lower surface area of the wavelength converter 320 may be in a range of 100% to 120% of an upper surface area of the light emitting diode chip 310. In this embodiment, the light emitting module 4000 includes the single wavelength converter 320, and the white wall 340 surrounds the wavelength converter 320. The white wall 340 may be formed to have various widths W4, W5, W6, and W7 around the wavelength converter 320. A first width W4 of the white wall 340 is a minimum width of the white wall 340 disposed around the wavelength converter 320. A second width W5 of the white wall is a width of the white wall disposed opposite to a region of the white wall 340 defining the first width W4. Meanwhile, a third width W6 and a fourth width W7 of the white wall 340 may be defined above and below the wavelength converter 320, respectively.

The width W1 of the light emitting diode chip 310 may be about 300 um or more and 1100 um or less, and the width W2 of the wavelength converter 320 may be about 400 um or more and 1200 um or less. The first width W4 of the white wall 340 is formed as the minimum width among the widths W4 through W7 of the white wall 340 disposed around the wavelength converter 320. The first width W4 exceeds about 100 um, and may further exceed 200 um. The second width W5 of the white wall 340 is larger than the first width W4 of the white wall 340, and may be approximately 300 um or more and 1300 um or less. The second width W5 of the white wall 340 may be equal to or larger than the width W2 of the wavelength converter 320. The second width W5 may be a largest among the widths W1 through W4 of the white wall 340.

Meanwhile, the third width W6 and the fourth width W7 of the white wall 340 may be same or different from each other. As such, the light emitting module 400 may be formed such that the white wall 340 disposed around the wavelength converter 320 has various widths W4, W5, W6, and W7, and by adjusting the minimum width W4, glare between adjacent light emitting modules may be prevented. By using the minimum width W4 of the white wall 340, it is possible to prevent glare of light emitted from the wavelength converter 320 even when a side surface of the wavelength converter 320 is vertical. The white wall 340 is disposed on the circuit board 400, and surrounds the light emitting diode chip 310 and the wavelength converter 320. A total area of a lower surface of the white wall 340 may be larger than that of an upper surface thereof. As shown in FIG. 8, an inner surface of the white wall 340 formed around the light emitting diode chip 310 may be inclined differently from an outer surface of the white wall 340. The inner surface of the white wall 340 may include regions with different inclination angles or regions with different curvatures. The white wall 340 may be in contact with the light emitting diode chip 310, but the inventive concepts are not limited thereto. At least a portion of the inner surface of the white wall 340 adjacent to a side surface of the light emitting diode chip 310 may be spaced apart from the side surface of the light emitting diode chip 310, and a gap may be formed in at least a portion of a region between the side surface of the light emitting diode chip 310 and the inner surface of the white wall 340.

In an embodiment, the upper surface of the white wall 340 may be flush with the upper surface of the wavelength converter 320. However, the present disclosure is not limited thereto, and the upper surface of the white wall 340 may be disposed lower than the upper surface of the wavelength converter 320.

In addition, the upper surface of the white wall 340 may be flat, without being limited thereto, and may be formed concave or convex. Moreover, the white wall 340 may have a smaller thickness as it is apart from the wavelength converter 320.

The light-transmitting adhesive layer 350 is disposed between the wavelength converter 320 and the light emitting diode chip 310, and attaches the wavelength converter 320 to the light emitting diode chip 310. The light-transmitting adhesive layer 350 may be disposed between the wavelength converter 320 and the light emitting diode chip 310. The light-transmitting adhesive layer 350 transmits light generated by the light emitting diode chip 310, and may be formed using an organic adhesive such as silicone resin or epoxy resin, or an inorganic adhesive such as low-melting-point glass. Furthermore, the light-transmitting adhesive layer 350 may include a light diffuser, and may be formed of, for example, a transparent resin including a light diffuser.

The light-transmitting adhesive layer 350 may cover at least a portion of the side surface of the light emitting diode chip 310. The light-transmitting adhesive layer 350 may fill a gap between the side surface of the light emitting diode chip 310 and the inner surface of the white wall 340. Accordingly, the light-transmitting adhesive layer 350 may have a first light-transmitting layer 350a disposed between the light emitting diode chip 310 and the wavelength converter 320, and a second light-transmitting layer 350b disposed between the side surface of the light emitting diode chip 310 and the inner surface of the white wall 340. The first light-transmitting layer 350a has a thickness smaller than that of the wavelength converter 320. Furthermore, the first light-transmitting layer 350a may have the thickness smaller than that of the bonding material 360.

The second light-transmitting layer 350b has an upper surface, a lower surface, and a connection portion connecting the upper surface and the lower surface. One side surface of the connection portion may be in contact with the inner surface of the white wall 340, and the other side surface may be in contact with the side surface of the light emitting diode chip 310. The upper surface of the second light-transmitting layer 350b may be in contact with the lower surface of the wavelength converter 320. A width of the upper surface of the second light-transmitting layer 350b is larger than that of the lower surface. The width of the upper surface of the second light-transmitting layer 350b may be about 10 um or more and 35 um or less, and further, 15 um or more and 30 um or less. Lengths of one side surface and the other side surface of the connection portion of the second light-transmitting layer 350b may be different from each other. In addition, one side surface and the other side surface of the connection portion may have different inclination angles, and at least a portion of one side surface or the other side surface may have a curved area. In an embodiment, one side surface or the other side surface may include regions with different inclinations or regions with different curvatures.

Various embodiments of the present disclosure have been described in the above, but the inventive concepts are not limited only to the above embodiments. In addition, features or components of an embodiment can also be applied to other embodiments without departing from the spirit and scope of the present disclosure.

## Claims

1. A light emitting module, comprising:
a substrate;
a plurality of light emitting diode chips disposed on the substrate;
a plurality of wavelength converters respectively disposed on the plurality of light emitting diode chips; and
a white wall surrounding the plurality of light emitting diode chips and the plurality of wavelength converters,
wherein each of the plurality of wavelength converters includes a side surface inclined at an inclination angle of 80 degrees or less with respect to an upper surface of the wavelength converter.

2. The light emitting module of claim 1,
wherein the substrate includes an upper surface circuit pattern, a lower surface circuit pattern, and a via connecting the upper surface circuit pattern and the lower surface circuit pattern.

3. The light emitting module of claim 1,
wherein an upper surface area of each of the wavelength converters is larger than a lower surface area thereof.

4. The light emitting module of claim 3,
wherein the lower surface area of the wavelength converters is in a range of 95% to 105% of an upper surface area of the light emitting diode chip.

5. The light emitting module of claim 4,
wherein the lower surface area of the wavelength converters is smaller than the upper surface area of the light emitting diode chip.

6. The light emitting module of claim 1,
wherein intervals between the wavelength converters are 100 um or less.

7. The light emitting module of claim 6,
wherein the intervals between the wavelength converters are 70 um or less.

8. The light emitting module of claim 1,
wherein the inclination angle is 70 degrees or less.

9. The light emitting module of claim 1,
wherein thicknesses of the wavelength converters are smaller than those of the light emitting diode chips.

10. The light emitting module of claim 1,
wherein an interval between lower surfaces of the wavelength converters is greater than an interval between the upper surfaces of the wavelength converters by more than 1/2 time of the thickness of the wavelength converter.

11. The light emitting module of claim 1, wherein:
the intervals between the wavelength converters are 100 um or less, and
in a luminance graph obtained by driving a single light emitting diode chip, a luminance at a position where it is 250 µm away from an edge of the wavelength converter corresponding to the single light emitting diode chip is less than 1/250 of a maximum luminance.

12. The light emitting module of claim 1, wherein:
the intervals between the wavelength converters are 100 um or less, and
in the luminance graph obtained by driving the single light emitting diode chip, a luminance at a position where it is 250 um away from a point showing 10% luminance of the maximum luminance thereof is less than 1/200 of the maximum luminance.

13. A light emitting module, comprising:
a substrate;
a plurality of light emitting diode chips disposed on the substrate;
a plurality of wavelength converters respectively disposed on the plurality of light emitting diode chips; and
a white wall surrounding the plurality of light emitting diode chips and the plurality of wavelength converters,
wherein intervals between the wavelength converters are 100 um or less, and
in a luminance graph obtained by driving a single light emitting diode chip, a luminance at a position where it is 250 µm away from an edge of the wavelength converter corresponding to the single light emitting diode chip is less than 1/250 of a maximum luminance.

14. The light emitting module of claim 13,
wherein the intervals between the wavelength converters are 70 um or less.

15. The light emitting module of claim 14,
wherein the intervals between the wavelength converters are 50 um or less.

16. The light emitting module of claim 13,
wherein thicknesses of the wavelength converters are smaller than those of the light emitting diode chips.

17. A headlamp comprising a light emitting module, the light emitting module, comprising:
a substrate;
a plurality of light emitting diode chips disposed on the substrate;
a plurality of wavelength converters respectively disposed on the plurality of light emitting diode chips; and
a white wall surrounding the plurality of light emitting diode chips and the plurality of wavelength converters,
wherein each of the plurality of wavelength converters includes a side surface inclined at an inclination angle of 80 degrees or less with respect to an upper surface of the wavelength converter.

18. The headlamp of claim 17, wherein:
intervals between the wavelength converters are 100 um or less, and
in a luminance graph obtained by driving a single light emitting diode chip, a luminance at a position where it is 250 µm away from an edge of the wavelength converter corresponding to the single light emitting diode chip is less than 1/250 of a maximum luminance.

19. The headlamp of claim 17, wherein:
the intervals between the wavelength converters are 100 um or less, and
in the luminance graph obtained by driving the single light emitting diode chip, a luminance at a position where it is 250 um away from a point showing 10% luminance of the maximum luminance thereof is less than 1/200 of the maximum luminance.

20. A light emitting module, comprising:
a substrate;
a single light emitting diode chip disposed on the substrate;
a single wavelength converter disposed on the light emitting diode chip; and
a white wall surrounding the light emitting diode chip and the wavelength converter,
wherein a width of an upper surface of the wavelength converter is greater than a width of an upper surface of the light emitting diode chip.
